(19) Europäisches Patentamt
European Patent Office
Office européen des brevets

(11) EP 0 849 795 A2

# (12) EUROPEAN PATENT APPLICATION

(43) Date of publication:
**24.06.1998 Bulletin 1998/26**

(51) Int. Cl.$^6$: **H01L 23/498**, H01L 23/538

(21) Application number: **97119324.8**

(22) Date of filing: **05.11.1997**

(84) Designated Contracting States:
**AT BE CH DE DK ES FI FR GB GR IE IT LI LU MC NL PT SE**
Designated Extension States:
**AL LT LV MK RO SI**

(30) Priority: **17.12.1996 US 768139**

(71) Applicant: **LSI LOGIC CORPORATION**
**Milpitas, CA 95035 (US)**

(72) Inventors:
- **Eslamy, Mohammad**
  **San Jose, California 95164 (US)**
- **Raab, Kurt R.**
  **San Jose, California 95118 (US)**
- **McCormick, John**
  **Palo Alto California 94306 (US)**

(74) Representative:
**Casalonga, Axel et al**
**BUREAU D.A. CASALONGA - JOSSE**
**Morassistrasse 8**
**80469 München (DE)**

## (54) Adhesive promotion of TAB/FLEX tape in a laminar electronic package contruction

(57) A method and apparatus for connecting a Tape Automated Bonding (TAB) film to a baseplate. The baseplate may be a heat spreader having a cavity for receiving a semiconductor chip disposed within the TAB film. A pressure-sensitive adhesive coupon may be positioned between the TAB film and the baseplate, thereby connecting the TAB film to the baseplate. An adhesion promoter containing an organofunctional group and a silicon-functional group may be disposed between the adhesive coupon and each of its mating surfaces (i.e., the TAB film and the baseplate) to increase adhesion between the adhesive coupon and the mating surfaces. The adhesion promoter preferably forms covalent bonds with the adhesive coupon and with each of the mating surfaces.

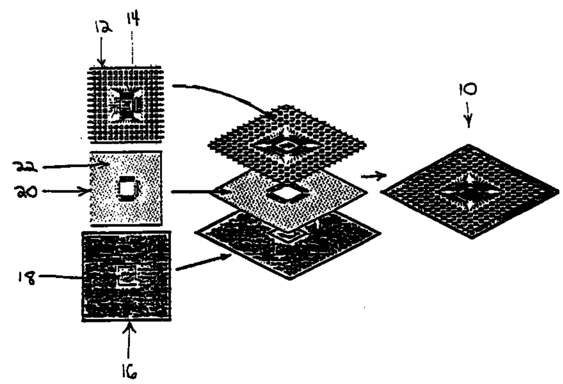


FIG. 1

EP 0 849 795 A2

Printed by Xerox (UK) Business Services
2.16.3/3.4

**Description**

## BACKGROUND OF THE INVENTION

1. Field of the Invention

The present invention generally relates to electronic package constructions. More particularly, an embodiment of the invention relates to an electronic package construction that includes a baseplate and a tape automated bonding (TAB) film connected by an adhesive coupon disposed therebetween.

2. Description of the Related Art

Some electronic package constructions produced by Tape Automated Bonding (TAB) processes contain a TAB film disposed around a semiconductor chip. TAB processes used in the production of flexible circuits are well known to those skilled in the art. In some arrangements, the TAB film and semiconductor chip are connected to a heat spreader to facilitate the dissipation of heat from the chip and leads contained in the TAB film. An electronic package construction having a TAB film connected to a heat spreader may include a layer of two-sided adhesive material (e.g., pressure-sensitive adhesive tape) positioned between the TAB film and the heat spreader to affix the TAB film to the heat spreader. The adhesive material typically adheres to its mating surfaces (i.e., the surfaces of the heat spreader and the TAB film) as a result of relatively weak interaction forces (e.g., Van der Waals forces).

The adhesion strength imparted by the adhesive material is frequently insufficient to maintain an adequate connection between the TAB film and the heat spreader when the construction is subjected to standard environmental tests. In addition, it has been found that ambient moisture is often sufficient to disrupt the attractive forces between the adhesive material and the mating surfaces, resulting in delamination of the adhesive material from one or both of the mating surfaces.

It is therefore desirable that an improved coupling mechanism be derived for certain electronic package constructions to increase adhesion between the TAB film and the heat spreader.

## SUMMARY OF THE INVENTION

In accordance with the present invention, an electronic package construction is provided that largely eliminates or reduces the aforementioned disadvantages of certain conventional electronic package constructions. An embodiment of the invention relates to an electronic package construction that includes (a) a tape automated bonding film containing an organic material, (b) a baseplate containing an inorganic material, and (c) an adhesive coupon positioned between the tape automated bonding film and the baseplate. An adhesion promoter is preferably disposed (a) between the top surface of the adhesive coupon and the tape automated bonding film and (b) between the bottom surface of the adhesive coupon and the baseplate. The adhesion promoter preferably includes an organofunctional group and silicon. The adhesion promoter preferably adheres to the tape automated bonding film and to the top surface of the adhesive coupon to increase adhesion between the tape automated bonding film and the adhesive coupon. The adhesion promoter also preferably adheres to the baseplate and to the bottom surface of the adhesive coupon to increase adhesion between the baseplate and the adhesive coupon.

The adhesion promoter is preferably covalently bonded with the tape automated bonding film and covalently bonded with the adhesive coupon to increase adhesion between the tape automated bonding film and the top surface of the adhesive coupon. The adhesion promoter is also preferably covalently bonded with the baseplate and covalently bonded with the adhesive coupon to increase adhesion between the baseplate and the bottom surface of the adhesive coupon.

The adhesion promoter preferably includes the structure $X_3$-Si-R-Y, wherein Y represents the organofunctional group, R represents an alkyl group, and each X represents a silicon-functional group. The organofunctional group is preferably selected from the group consisting of Cl, $NH_2$, SH, CH=CH2, N=C=O, $CH_2$,

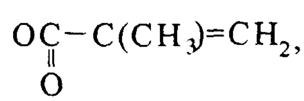 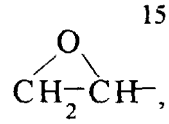

and R', wherein R' represents a chain of atoms comprising carbon atoms. At least one of the silicon-functional groups is preferably selected from the group consisting of $OCH_3$, $OC_2H_5$, $OC_2H_4OCH_3$, and O-R', wherein R' represents a chain of atoms comprising carbon atoms. The organofunctional group is preferably covalently bonded to the bottom surface of the adhesive coupon and at least one of the silicon-functional groups is preferably covalently bonded to inorganic material of the baseplate. Some of the silicon-functional groups of the adhesion promoter may undergo condensation reactions with neighboring silicon-functional groups to form substantially water-resistant cross-links.

The baseplate may be a heat spreader made of a metal that has a relatively high thermal conductivity. The adhesive coupon may be a pressure-sensitive adhesive coupon containing an organic material. The adhesive coupon may contain a polymer having polyimide repeat units. The adhesive coupon may further include a plurality of ceramic particles (e.g., $Al_2O_3$) that serve as sites where silicon-functional groups of the adhesion

promoter covalently bond with the adhesive coupon.

The assembly of the electronic package construction may include a step of disposing the adhesion promoter between the bottom surface of the adhesive coupon and the baseplate in which the aqueous adhesion promoter solution is applied onto the baseplate. The assembly of the electronic package construction may further include a step of disposing the adhesion promoter between the top surface of the adhesive coupon and the tape automated bonding film in which an aqueous adhesion promoter solution is applied onto the tape automated bonding film. The aqueous adhesion promoter solution may include between about 0.05 percent and about 5 percent adhesion promoter.

The step of disposing the first adhesion promoter between the top surface of the adhesive coupon and the tape automated bonding film may further include (a) immersing the tape automated bonding film into a solution comprising the adhesion promoter, (b) removing moisture from the tape automated bonding film, and (c) positioning the tape automated bonding film proximate the top surface of the adhesive coupon. Moisture may be removed from the tape automated bonding film by drying the tape automated bonding film in an environment having a temperature between about 70°C and about 100°C for less than about 10 minutes.

The step of disposing the first adhesion promoter between the bottom surface of the adhesive coupon and the baseplate may further include (a) immersing the baseplate into a solution comprising the adhesion promoter, (b) removing moisture from the baseplate, and (c) positioning the baseplate proximate the bottom surface of the adhesive coupon. Moisture may be removed from the baseplate by drying the tape automated bonding film in an environment having a temperature between about 70°C and about 100°C for less than about 10 minutes.

After application of the adhesion promoter between the adhesive coupon and each of its mating surfaces, the tape automated bonding film, the adhesive coupon, and the baseplate may be laminated together to form a laminar construction.

An advantage of the invention relates to maintaining an adequate connection between a baseplate and a TAB film in an electronic package construction.

Another advantage of the invention relates to promoting adhesion between an adhesive material and its adjacent mating surfaces by creating primary bonding between the adhesive material and each of the mating surfaces.

Yet another advantage of the invention relates to providing an electronic package construction adapted to withstand a JEDEC level III environmental test.

Still another advantage of the invention relates to imparting water repellency to the interfaces between an adhesive material and each of its mating surfaces.

## BRIEF DESCRIPTION OF THE DRAWINGS

Further advantages of the present invention will become apparent to those skilled in the art with the benefit of the following detailed description of the preferred embodiments and upon reference to the accompanying drawings in which:

Figure 1 depicts the assembly of portion of an electronic package construction including a TAB film, an adhesive coupon, and a baseplate.

Figure 2 depicts an adhesion promoter bonding with an inorganic substrate.

Figure 3 depicts an adhesion promoter bonding with a polymer chain terminating in an isocyanato group.

Figure 4 depicts an adhesion promoter having an isocyanato group bonding with a polymer chain.

Figure 5 depicts an adhesion promoter bonding with a polymer chain through an addition reaction with an unsaturated group on the polymer chain.

Figure 6 depicts an adhesion promoter having an unsaturated group bonding with a polymer at a site on the backbone of the polymer that contains a free radical.

Figure 7 depicts cross-links formed between silane-functional groups of an adhesion promoter disposed between a organic substrate ad an inorganic substrate.

Figure 8 depicts cross-links formed between silane-functional groups of an adhesion promoter disposed between two organic substrates.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, equivalents and alternatives falling within the spirit and scope of the present invention as defined by the appended claims.

## DETAILED DESCRIPTION

Figure 1 depicts components included in an embodiment of an electronic package construction. The package construction 10 preferably includes a tape automated bonding (TAB) or Flex-Tape film 12 bonded to contact points or "pads" of an integrated circuit chip

14. The assembly of the TAB film ad integrated circuit chip may be accomplished by TAB processes well known to those skilled in the art. The TAB film preferably contains a polyimide material characterized by the chemical structure:

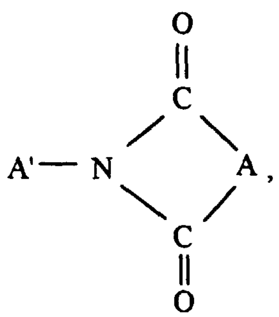

where A' and A are aromatic groups.

In an embodiment, the TAB film is a Tape Ball Grade Array (TBGA) tape available from Shindo or Hitachi, each located in Japan. The TAB film may instead include polyimide compounds such as Kapton® or Upilex®. Kapton® is commercially available from DuPont, and Upilex® is commercially available from Ube industries of Japan. In an alternate embodiment the TAB film or tape includes polyester material such as Mylar®, which is available from DuPont. The TAB film material preferably contains an organic polymer having a relatively low dielectric constant and a relatively high dielectric strength. The thickness of the TAB film is typically between about 0.5 mil and about 5 mil (1 mil equals 0.001 inch). Although the package construction illustrated in Figure 1 employs a pin grid array package configuration, it is to be understood that embodiments of the present invention are applicable to various other package configurations including flat pack configurations.

The package construction also preferably includes a baseplate 16. The baseplate preferably serves as a heat spreader to facilitate the dissipation of thermal energy from semiconductor chip 14. The baseplate preferably contains a cavity 18 to receive the semiconductor chip. The cavity preferably has a depth between about 10 mil and about 30 mil. The baseplate preferably is constructed of one or more materials having a relatively high thermal conductivity. The baseplate preferably is made of a metal such as copper or aluminum, but also may be made of other suitable materials including silicon. In an embodiment of the invention, the baseplate contains a nickel or copper base material. The baseplate preferably contains a copper base, nickel plating, and a gold finish. The base plate may be heat spreader contained entirely within the package construction or a heat slug having a surface within the package construction proximate semiconductor chip 14 and another surface exposed from the package construction. In an alternate embodiment, the baseplate is an inorganic plate primarily serving to support semiconductor chip 14.

An adhesive coupon 20 is preferably disposed between the baseplate and the TAB film. In an embodiment of the invention, the coupon is a two sided pressure-sensitive adhesive (PSA) tape. Such PSA tape may adhere to the TAB film and the baseplate as a result of relatively weak secondary forces such as Van der Waals forces and the like. It has been found that the relatively weak secondary forces between the PSA tape and its mating surfaces (e.g., base plate, TAB film) are typically not strong enough to prevent the PSA tape from delaminating from the baseplate and/or TAB film when the package construction is subjected to harsh environmental conditions such as relatively high levels of heat and/or humidity. The PSA tape may also delaminate from its mating surfaces after relatively long periods under normal environmental conditions. In an embodiment, the adhesive coupon is pressure-sensitive adhesive, commercially available from Chomerics, Inc., located in Woburn, Massachusetts.

In an embodiment of the invention, an adhesion promoter is disposed between the bottom surface of adhesive coupon 20 and baseplate 16 to increase adhesion (a) between the coupon and the adhesion promoter and (b) between the baseplate and the adhesion promoter. The adhesion promoter may form relatively strong secondary bonds (e.g. hydrogen bonds) with the adhesive coupon and with the baseplate. It is preferred that the adhesion promoter forms primary (i.e., covalent) bonds with the adhesive coupon and with the baseplate. The adhesion promoter is also preferably disposed between the top surface of adhesive coupon 20 and TAB film 12 to increase adhesion (a) between the coupon and the adhesion promoter and (b) between the TAB film and the adhesion promoter. The adhesion promoter may form relatively strong secondary bonds with the adhesive coupon and with the TAB film. It is preferred that the adhesion promoter covalently bonds with the adhesive coupon and with the TAB film. Thus the baseplate and the TAB film are preferably coupled together by an adhesive coupon that is covalently bonded to each of the baseplate and the TAB film with the aid of an adhesion promoter. Covalent bonds formed by the sharing of electrons between atoms tend to be stronger than secondary forces. Therefore, the adhesion promoter allows a stronger coupling between the baseplate and the TAB film as compared to mechanisms (e.g.. PSA tape alone) that rely solely on secondary forces to connect the TAB film to the baseplate.

In an embodiment of the invention, the adhesion promoter includes organofunctional groups that are adapted to covalently bond with carbon-containing materials and includes silicon-functional groups that are adapted to covalently bond with inorganic materials. The different reactive groups allow the adhesion promoter to simultaneously covalently bond with both

organic and inorganic substrates. The TAB film preferably includes an organic polymer base (e.g., polyimide, polyester) that may form primary bonds with the organofunctional groups, and the baseplate preferably includes inorganic material (e.g. metal) that may form primary bonds with the silicon-functional groups.

In an embodiment of the invention, the adhesive coupon contains a plurality of inorganic particles 22 (shown in Figure 1) that may facilitate the dissipation of thermal energy generated from leads contained in the TAB film. The inorganic particles preferably are ceramic (e.g., $Al_2O_3$) particles having a relatively high thermal conductivity. The particles are preferably imbedded in and exposed from the top surface of the adhesive coupon. In an embodiment, the particles include alumina and may cover between about 60% and about 70% of the surface of the adhesive coupon. The particles preferably serve as connection sites where covalent bonds are formed with the silicon-functional groups of the adhesion promoter.

The adhesion promoter preferably includes the chemical structure $X_3$-Si-R-Y, where Y represents an organofunctional group, X represents a silicon-functional group (e.g., alkoxy group), and R preferably represents an alkyl group. In an embodiment, the R group is $(CH_2)_3$. The organofunctional group preferably includes Cl, $NH_2$, SH, CH=CH2, N=C=O,

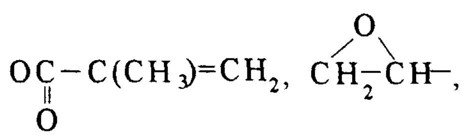

$CH_2$-R' (where R' represents a chain containing carbon atoms), or other similar structures. The silicon functional groups may include $OCH_3$, $OC_2H_5$, $OC_2H_4OCH_3$, O-R' (where R' represents a chain containing carbon atoms), or other similar structures.

The adhesion promoter is preferably thermally conductive to facilitate the dissipation of heat from the package construction. In an embodiment of the invention, the adhesion promoter has a thermal conductivity between about 0.3 $\frac{W}{m \cdot K}$ and about 0.45 $\frac{W}{m \cdot K}$.

The adhesion promoter may bond to the baseplate by a two-step mechanism illustrated in Figure 2. The first step may include the hydrolysis of a silicon-functional group of the adhesion promoter to form silanol groups and an alcohol. In Figure 2, R represents an alkyl group, and R' represents a chain of atoms that includes carbon atoms. In the second step, one of the silanol groups condenses with a hydroxyl group on the surface of an inorganic mating substrate. In cases where the baseplate contains a metal surface, a silanol group of the adhesion promoter may react with a metal oxide layer on the surface of the metal. If the adhesive coupon contains ceramic particles 22, the adhesion promoter may bond to the ceramic particles in the same way that it bonds to the inorganic mating surface depicted in Figure 2.

The organofunctional group of the adhesion promoter may bond with organic material of the adhesive coupon and with the organic material of the TAB film by various mechanisms that depend upon the nature of the organofunctional group, the TAB film, and the adhesive coupon. For instance, the adhesion promoter may bond to an end group of an organic polymer included in the adhesive coupon or the TAB film through a condensation reaction, addition reaction, or other known mechanism. The organofunctional groups of the adhesion promoter preferably form at least strong secondary bonds with the adhesive coupon and/or the TAB film, and more preferably form primary covalent bonds with the adhesive coupon and/or the TAB film.

Figures 3-6 and the following description relating thereto are intended to merely illustrate the bonding of the organofunctional group of an adhesion promoter to a substrate surface in some embodiments of the present invention. It is to be understood that the depictions in Figures 3-6 are not exhaustive and that the present invention encompasses a number of additional alternative embodiments as will be recognized by one skilled in the art. The R groups in Figures 3-6 are preferably alkyl groups, and more preferably the group $(CH_2)_3$. In addition, the groups bonded to the silicon atoms in Figures 3-6 are not shown. It is to be understood that the silicon atoms may be bonded to a substrate or mating surface and/or may be bonded to various silicon-functional groups that may be hydrolyzed or unhydrolyzed.

The bonding of the organofunctional group of an adhesion promoter to a polymer chain terminating in an isocyanato group (i.e., N=C=O) is illustrated in Figure 3. In one embodiment, group Z represents NH. In another embodiment, group Z represents a sulfur atom. Figure 3B illustrates the bonding of the organofunctional group in adhesion promoter formulation A-1170® to both ends of a polymer chain terminating at each end in an isocyanato group. The polymer chain depicted in Figure 3B may be a portion of the adhesive coupon with the silicon atom being covalently bonded with the baseplate through at least one silicon-functional group (not shown). In addition, the TAB film may contain metal exposed from its bottom surface that provides a site for covalent bonding with the silicon-functional groups of the adhesion promoter. Alternately, the polymer chain may be the TAB film and the silicon atom may be bonded through a silicon-functional group to (a) a ceramic particle on the adhesive coupon or (b) organic material of the adhesive coupon.

In an embodiment of the invention, an adhesion promoter having an isocyanato group as an organofunctional group is bonded with a polymer (e.g., adhesive coupon, TAB film) as depicted in Figures 4A and 4B. Figure 4A illustrates the reaction of the isocyanato

group and a hydroxyl group provided on the end of a polymer chain. Figure 4B illustrates the reaction of the isocyanato group and an amine group on the end of the polymer chain.

In an embodiment of the invention illustrated in Figures 5A and 5B, the organofunctional group of an adhesion promoter is bonded with a polymer (e.g., adhesive coupon, TAB film) through an addition reaction with an unsaturated group on the polymer chain. Figure 5A depicts an adhesion promoter having $NH_2$ as the organofunctional group, and Figure 5B depicts an adhesion promoter having SH as the organofunctional group.

In an embodiment of the invention illustrated in Figures 6A and 6B, an adhesion promoter having an organofunctional group that contains an unsaturated end may be bonded with a polymer (e.g. adhesive coupon, TAB film) at a reactive site on the backbone of the polymer. Figures 6A and 6B each depict a free radical addition reaction between the unsaturated end and a polymer branch having an unshared electron.

The adhesion promoter is preferably contained in a solution during its application to the mating surface(s) of the electronic package construction. In an embodiment of the invention, the baseplate and/or TAB film is immersed in a solution containing the adhesion promoter. It is to be understood that the adhesion promoter may be applied to the baseplate and/or TAB film by other methods as well. For instance, the solution containing the adhesion promoter may be sprayed from a nozzle onto the surfaces of the baseplate and/or TAB film. The adhesion promoter is preferably evenly distributed across the surfaces of the baseplate and/or TAB film. A monolayer of adhesion promoter preferably forms on the surfaces of the baseplate and/or TAB film. After the adhesion promoter is applied to the baseplate and/or the TAB film, the baseplate and/or TAB film are preferably dried to remove excess moisture. In an embodiment, the drying includes heating the mating surface(s) in an environment having a temperature of about 80°C for between about 5 minutes and about 10 minutes or until a selected amount of moisture is removed. After drying, the adhesive coupon, the baseplate, and/or the TAB film may be engaged and laminated together in a lamination press. Lamination processes are well known to those skilled in the art.

In an embodiment, a first adhesion promoter is used to couple the TAB film to the adhesive coupon, and a second adhesion promoter that is unidentical to the first adhesion promoter is used to couple the baseplate to the adhesive coupon.

In some instances, it may be preferred that the adhesion promoter be applied to only one surface of the baseplate and/or TAB film. In an embodiment of the invention, the adhesion promoter is applied directly to the adhesive coupon. The adhesion promoter may be applied to one or both surfaces of the adhesive coupon depending on whether the adhesion promoter is to be used to bond the adhesive coupon to only a single mating surface or both the baseplate and the TAB film. The adhesion promoter may be applied to the adhesive coupon by various methods (e.g., spraying), but is preferably applied by immersing the adhesive coupon in a solution that contains the adhesion promoter. The adhesive coupon is preferably dried at about 80°C for between about 5 and about 10 minutes, or until a selected amount of moisture is removed. The adhesion promoter is preferably evenly distributed to form a monolayer on the surfaces of the adhesive coupon. After moisture is removed from the adhesive coupon, the coupon may be "sandwiched" between the baseplate and the TAB film to covalently bond the mating surface(s) to the coupon. The components may be laminated to form a laminar construction.

The adhesion promoter is preferably soluble in water and applied the mating surfaces in an aqueous solution. It is to be understood that a number of adhesion promoters useful in the present invention may instead be soluble in organic solvents, however, it is generally preferred that the adhesion promoter be in an aqueous solution to facilitate handling and/or disposal of the solution. The solution preferably contains from about 0.5 percent to about 5 percent adhesion promoter.

It has been found that one adhesion promoter that performs adequately in embodiments of the present invention is formulation A-1100®, commercially available from Union Carbide Specialty Chemicals, located in Danbury, Connecticut. Formulation A-1100® has the chemical structure $X_3$-Si-R-Y, where Y represents $NH_2$ and R represents $(CH_2)_3$. It is to be understood that a number of other adhesion promoters could be used including formulations A-1110®, A-1120®, A-1130®, A-189®, and A-1170®, all commercially available from Union Carbide. Those skilled in the art will recognize that a number of other known silane coupling agents are applicable to embodiments of the present invention.

It has been found that in the absence of the adhesion promoters described above, moisture tends to contribute to the delamination of the adhesive coupon from the baseplate and/or TAB film. In some cases, exposure of the electronic package construction to ambient moisture over a period of time is sufficient to cause delamination. In an embodiment of the invention, moisture induces chemical cross-linking between neighboring adhesion promoter molecules to form a cross-linked network that improves the coupling strength between the adhesive coupon and the mating surface(s). In this manner, the adhesion promoter preferably induces the formation of substantially water-resistant bonding between the adhesive coupon and the mating surface(s). It is to be understood that for the purpose of this description, "cross-linking" is not limited to linking between polymer chains. "Cross-linking" may be taken to also include any primary bonding between or among neighboring adhesion promoter molecules. Ambient moisture is preferably sufficient to induce cross-linking

to improve the coupling strength between the adhesive coupon and its mating surfaces.

Figure 7 illustrates cross-linking between silane-functional groups in an embodiment of the invention. The silane-functional groups of the adhesion promoter may bond to the surface of a ceramic particle or an inorganic substrate in a manner similar to that depicted in Figure 2. The organofunctional groups of the adhesion promoter may bond to an organic material or polymer chain contained in the adhesive coupon or TAB film by a mechanism similar to one of those illustrated in Figures 3-6. Through condensation between neighboring silanol groups, the silicon atoms of adjacent adhesion promoter molecules may form cross-links such as the siloxane structures shown in Figure 7. The silicon atoms may also form cross-links with atoms other than silicon (e.g., carbon atoms) that are contained on neighboring branches.

An embodiment of the invention in which adhesion promoter molecules disposed between the adhesive coupon and the TAB film are cross-linked is illustrated in Figure 8. The "Polymer Networks" in Figure 8 represent the adhesive coupon and the TAB film. Although not shown in Figure 8, it is to be understood that one or more organofunctional groups may be provided between the silicon atoms and the adhesive coupon and/or TAB film. The silicon atoms may be bonded to repeat units on the interior of one or more polymer chains or may be bonded to the end of a polymer chain. The silicon-functional groups may undergo a silyation reaction to bond to the polymer network. As shown in Figure 8, n (i.e., one or more) alcohols are formed and silanol groups are formed following the hydrolysis of the silicon-functional groups of the adhesion promoter. Ambient moisture is preferably sufficient to supply the water that hydrolyzes the silicon-functional groups. Adjacent silanol groups undergo a condensation reaction to produce a cross-linked polymer network in which neighboring silicon atoms are covalently bonded to a common oxygen atom.

It has been found that the adhesion promoter may significantly increase the laminar adhesion strength between the adhesive coupon and the mating surface(s). It is believed that the improved coupling strength largely results from (a) the formation of covalent bonds between the adhesive coupon and the mating surface(s) and/or (b) cross-linking between neighboring adhesion promoter molecules. It has been found that electronic package constructions assembled in accordance with the present invention may withstand a JEDEC level III test without the adhesive coupon delaminating from either the baseplate or the TAB film. A JEDEC level III test is know~ to those skilled in the art and includes subjecting the package construction to 85 percent humidity at a temperature of 85°C for a time period of 192 hours.

## Example

An electronic package construction including a strip of pressure-sensitive adhesive tape positioned between a TAB film of a flexible circuit and heat spreader was assembled in the following manner. The TAB film was TBGA tape. The heat spreader contained a copper base and included a surface plated with nickel and having a gold finish. The TAB film, pressure-sensitive adhesive tape, and heat spreader were laminated in a lamination press at room temperature and a pressure of 50 psig for a period of between 5 and 10 seconds. The pressure-sensitive adhesive tape had a width of 8 mm and a length of 40 mm. The tape and heat spreader were subjected to a peel test in which a force was applied to the tape in a direction opposite from the heat spreader. The tape delaminated from the heat spreader upon application of force having a magnitude of 1500 grams-force.

A second electronic package construction having substantially identical components as those describe above, was constructed in the same manner as described above except that the TAB film and heat spreader were each pre-treated with an adhesion promoter prior to assembly and lamination of the construction. The TAB film and the heat spreader were each dipped into an aqueous solution of 0.5 percent formulation A-1100® and then dried in an oven at 80°C for about 10 minutes. The pressure-sensitive adhesive tape was positioned between the TAB film and the heat spreader and the components were laminated as described above. After lamination, the tape and heat spreader were subjected to the peel test and the tape resisted delamination and maintained its engagement with the heat spreader when a force in excess of 1500 grams-force was applied to the tape in a direction opposite from the heat spreader.

Further modifications and alternative embodiments of various aspects of the invention will be apparent to those skilled in the art in view of this description. Accordingly, this description is to be construed as illustrative only and is for the purpose of teaching those skilled in the art the general manner of carrying out the invention. It is to be understood that the forms of the invention shown and described herein are to be taken as the presently preferred embodiments. Elements and materials may be substituted for those illustrated and described herein, parts and processes may be reversed, and certain features of the invention may be utilized independently, all as would be apparent to one skilled in the art after having the benefit of this description of the invention. Changes may be made in the elements described herein without departing from the spirit and scope of the invention as described in the following claims.

## Claims

1. An electronic package construction comprising:

   a tape automated bonding film comprising an organic material;

   a baseplate comprising an inorganic material;

   an adhesive coupon positioned between the tape automated bonding film and the baseplate, the adhesive coupon comprising a top surface and a bottom surface; and

   an adhesion promoter disposed (a) between the top surface of the adhesive coupon and the tape automated bonding film and (b) between the bottom surface of the adhesive coupon and the baseplate, the adhesion promoter comprising an organofunctional group and silicon, the adhesion promoter adhering to the tape automated bonding film and to the top surface of the adhesive coupon to increase adhesion between the tape automated bonding film and the top surface of the adhesive coupon, and the adhesion promoter adhering to the baseplate and to the bottom surface of the adhesive coupon to increase adhesion between the baseplate and the bottom surface of the adhesive coupon.

2. The electronic package construction of claim 1 wherein the adhesive coupon is a pressure-sensitive adhesive coupon.

3. The electronic package construction of claim 1 wherein the adhesion promoter is covalently bonded with the tape automated bonding film and covalently bonded with the adhesive coupon to increase adhesion between the tape automated bonding film and the top surface of the adhesive coupon, and wherein the adhesion promoter is covalently bonded with the baseplate and covalently bonded with the adhesive coupon to increase adhesion between the baseplate and the bottom surface of the adhesive coupon.

4. The electronic package construction of claim 1 wherein the baseplate is a heat spreader and the inorganic material is a metal.

5. The electronic package construction of claim 1 wherein the adhesion promoter comprises the structure $X_3$-Si-R-Y, wherein Y represents the organofunctional group, R represents an alkyl group, and each X represents a silicon-functional group.

6. The electronic package construction of claim 5 wherein the baseplate is a heat spreader comprising a metal surface, and wherein at least one of the silicon-functional groups is covalently bonded to the metal surface.

7. The electronic package construction of claim 5 wherein the organofunctional group is selected from the group consisting of Cl, $NH_2$, SH, CH=CH2, N=C=O, $CH_2$,

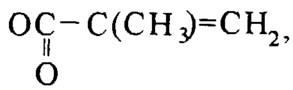 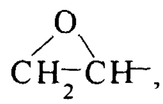,

and R', wherein R' represents a chain of atoms comprising carbon atoms.

8. The electronic package construction of claim 5 wherein at least one of the silicon-functional groups is selected from the group consisting of $OCH_3$, $OC_2H_5$, $OC_2H_4OCH_3$, and O-R', wherein R' represents a chain of atoms comprising carbon atoms.

9. The electronic package construction of claim 5 wherein the organofunctional group is covalently bonded to the bottom surface of the adhesive coupon and wherein at least one of the silicon-functional groups is covalently bonded to the inorganic material of the baseplate.

10. The electronic package construction of claim 1 wherein the adhesion promoter is selected from the group consisting of formulation A-1100®, formulation A-1110®, formulation A-1120®, formulation A-1130®, formulation A-1170®, and formulation A-189®.

11. The electronic package construction of claim 1 wherein the construction is adapted to withstand an environment having a temperature of at least about 121°C and a pressure of at least about 2 atm for about 96 hours without the adhesive coupon detaching from either the tape automated bonding film or the baseplate.

12. The electronic package construction of claim 1 wherein the construction is adapted to withstand a JEDEC level III test without the adhesive coupon detaching from either the tape automated bonding film or the baseplate.

13. The electronic package construction of claim 1 wherein the adhesive coupon has a laminar adhesion strength greater than about 1500 grams-force.

**14.** The electronic package construction of claim 5 wherein the adhesion promoter further comprises a plurality of silicon atoms forming chemical cross-links with other atoms.

**15.** The electronic package construction of claim 1, further comprising a semiconductor chip disposed within the tape automated bonding film, and wherein the baseplate further comprises a cavity adapted to receive the semiconductor chip, and wherein the adhesive coupon further comprises an opening alignable with the cavity to expose the cavity.

**16.** The electronic package construction of claim 5 wherein the adhesive coupon further comprises a ceramic particle and wherein at least one of the silicon-functional groups is covalently bonded with the ceramic particle.

**17.** An electronic package construction comprising:

a tape automated bonding film;

a heat spreader comprising an inorganic material;

an adhesive coupon comprising an organic material and positioned between the tape automated bonding film and the heat spreader to connect the tape automated bonding film and the heat spreader, the adhesive coupon comprising a bottom surface; and

an adhesion promoter disposed on the bottom surface of the adhesive coupon, the adhesion promoter comprising an organofunctional group and silicon, the adhesion promoter forming covalent bonds with the heat spreader and forming covalent bonds with the adhesive coupon to increase adhesion between the heat spreader and the bottom surface of the adhesive coupon.

**18.** A method of assembling an electronic package construction, comprising the steps of:

disposing a first adhesion promoter between a top surface of an adhesive coupon and a tape automated bonding film, and wherein the first adhesion promoter adheres to the top surface of the adhesive coupon and to the tape automated bonding film, thereby increasing adhesion between the top surface of the adhesive coupon and the tape automated bonding film; and

disposing a second adhesion promoter between a bottom surface of the adhesive coupon and a baseplate, the second adhesion promoter comprising an organofunctional group and silicon, and wherein the second adhesion promoter adheres to the bottom surface of the adhesive coupon and to the baseplate, thereby increasing adhesion between the bottom surface of the adhesive coupon and the baseplate.

**19.** The method of claim 18 wherein the first adhesion promoter comprises an organofunctional group and a silicon-functional group.

**20.** The method of claim 18 wherein the step of disposing the first adhesion promoter between the top surface of the adhesive coupon and the tape automated bonding film comprises applying an aqueous adhesion promoter solution onto the tape automated bonding film, the aqueous adhesion promoter solution comprising between about 0.05 percent and about 5 percent adhesion promoter.

**21.** The method of claim 18 wherein the step of disposing the adhesion promoter between the top surface of the adhesive coupon and the tape automated bonding film comprises applying an adhesion promoter solution onto the tape automated bonding film, the adhesion promoter solution comprising an organic solvent and between about 0.05 percent and about 5 percent adhesion promoter.

**22.** The method of claim 18 wherein the step of disposing the adhesion promoter between the bottom surface of the adhesive coupon and the baseplate comprises applying an aqueous adhesion promoter solution onto the baseplate, the aqueous adhesion promoter solution comprising between about 0.05 percent and about 5 percent adhesion promoter.

**23.** The method of claim 18 wherein the step of disposing the adhesion promoter between the bottom surface of the adhesive coupon and the baseplate comprises applying an adhesion promoter solution onto the baseplate, the adhesion promoter solution comprising an organic solvent and between about 0.05 percent and about 5 percent adhesion promoter.

**24.** The method of claim 18 wherein the second adhesion promoter comprises the structure $X_3$-Si-R-Y, and wherein Y represents an organofunctional group, R represents an alkyl group, and each X represents a silicon-functional group.

**25.** The method of claim 18 wherein the organofunctional group is selected from the group consisting of Cl, $NH_2$, SH, CH=CH2, N=C=O, $CH_2$,

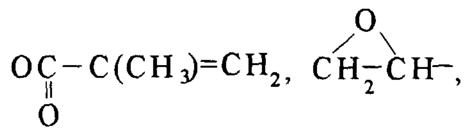

and R', wherein R' represents a chain of atoms comprising carbon atoms.

**26.** The method of claim 18 wherein at least one of the silicon-functional groups is selected from the group consisting of $OCH_3$, $OC_2H_5$, $OC_2H_4OCH_3$, and O-R', wherein R' represents a chain comprising carbon atoms.

**27.** The method of claim 24 wherein the organofunctional group covalently bonds with the bottom surface of the adhesive coupon, and wherein at least one of the silicon-functional groups covalently bonds with the inorganic material of the baseplate.

**28.** The method of claim 18 wherein the second adhesion promoter is selected from the group consisting of formulation A-1100®, formulation A-1100®, formulation A-1120®, formulation A-1130®, formulation A-1170®, and formulation A-189®.

**29.** The method of claim 18 wherein the first adhesion promoter adheres to the bottom surface of the adhesive coupon and to the tape automated bonding film by covalently bonding with the top surface of the adhesive coupon and with the tape automated bonding film, and wherein the second adhesion promoter adheres to the bottom surface of the adhesive coupon and to the baseplate by covalently bonding with the bottom surface of the adhesive coupon and with the baseplate.

**30.** The method of claim 18, further comprising laminating the tape automated bonding film, the adhesive coupon, and the baseplate together to form a laminar construction.

**31.** The method of claim 18 wherein the first adhesion promoter is substantially identical to the second adhesion promoter.

**32.** The method of claim 18 wherein the adhesive coupon is a pressure-sensitive adhesive coupon.

**33.** The method of claim 18 wherein the baseplate is a heat spreader comprising metal, and wherein the adhesion promoter covalently bonds to metal on a surface of the heat spreader to increase adhesion between the heat spreader and the adhesive coupon.

**34.** The method of claim 18 wherein the step of disposing the first adhesion promoter between the top surface of the adhesive coupon and the tape automated bonding film comprises (a) immersing the tape automated bonding film into a solution comprising the first adhesion promoter, (b) removing moisture from the tape automated bonding film, and (c) positioning the tape automated bonding film proximate the top surface of the adhesive coupon.

**35.** The method of claim 34 wherein the moisture is removed from the tape automated bonding film by drying the tape automated bonding film in an environment having a temperature between about 70°C and about 100°C for less than about 10 minutes.

**36.** The method of claim 18 wherein the step of disposing the second adhesion promoter between the bottom surface of the adhesive coupon and the baseplate comprises (a) immersing the baseplate into a solution comprising the second adhesion promoter, (b) removing moisture from the baseplate, and (c) positioning the baseplate proximate the bottom surface of the adhesive coupon.

**37.** The method of claim 36 wherein the moisture is removed from the baseplate by drying the baseplate in an environment having a temperature between about 70°C and about 100°C for less than about 10 minutes.

**38.** The method of claim 18 wherein the first adhesion promoter is substantially identical to the second adhesion promoter, and wherein the steps of (i) disposing the first adhesion promoter between the top surface of the adhesive coupon and the tape automated bonding film and (ii) disposing the second adhesion promoter between the bottom surface of the adhesive coupon and the baseplate together comprise (a) immersing the adhesive coupon into an adhesion promoter solution, (b) removing moisture from the adhesive coupon, (c) positioning the tape automated bonding film proximate the top surface of the adhesive coupon, and (d) positioning the baseplate proximate the bottom surface of the adhesive coupon.

**39.** The method of claim 19 wherein the adhesive coupon further comprises a ceramic particle, and wherein the silicon-functional group of the first adhesion promoter covalently bonds with the ceramic particle and the organofunctional group of the first adhesion promoter covalently bonds with the tape automated bonding film to increase adhesion between the tape automated bonding film and the adhesive coupon.

**40.** The method of claim 27 wherein the second adhesion promoter further comprises a plurality of silicon functional groups that covalently bond to the inorganic material of the baseplate, and wherein at least some of the silicon-functional groups covalently bond to neighboring silicon-functional groups to form siloxane structures.

**41.** The method of claim 39 wherein the adhesive coupon further comprises a plurality of ceramic particles, and wherein the first adhesion promoter further comprises a plurality of silicon-functional groups that covalently bond with the ceramic particles, and wherein at least some of the silicon-functional groups undergo condensation reactions with neighboring silicon-functional groups to form substantially water-resistant cross-links.

**42.** A method of assembling a laminar electronic package construction, comprising:

coupling an adhesive coupon to a tape automated bonding film such that a top surface of the adhesive coupon is coupled to a bottom surface of the tape automated bonding film;

disposing an adhesion promoter between a bottom surface of the adhesive coupon and a heat spreader, the adhesion promoter comprising an organofunctional group and silicon, and wherein the adhesion promoter covalently bonds with the bottom surface of the adhesive coupon and with the heat spreader, thereby increasing adhesion between the bottom surface of the adhesive coupon and the heat spreader; and

laminating the tape automated bonding film, the adhesive coupon, and the baseplate.

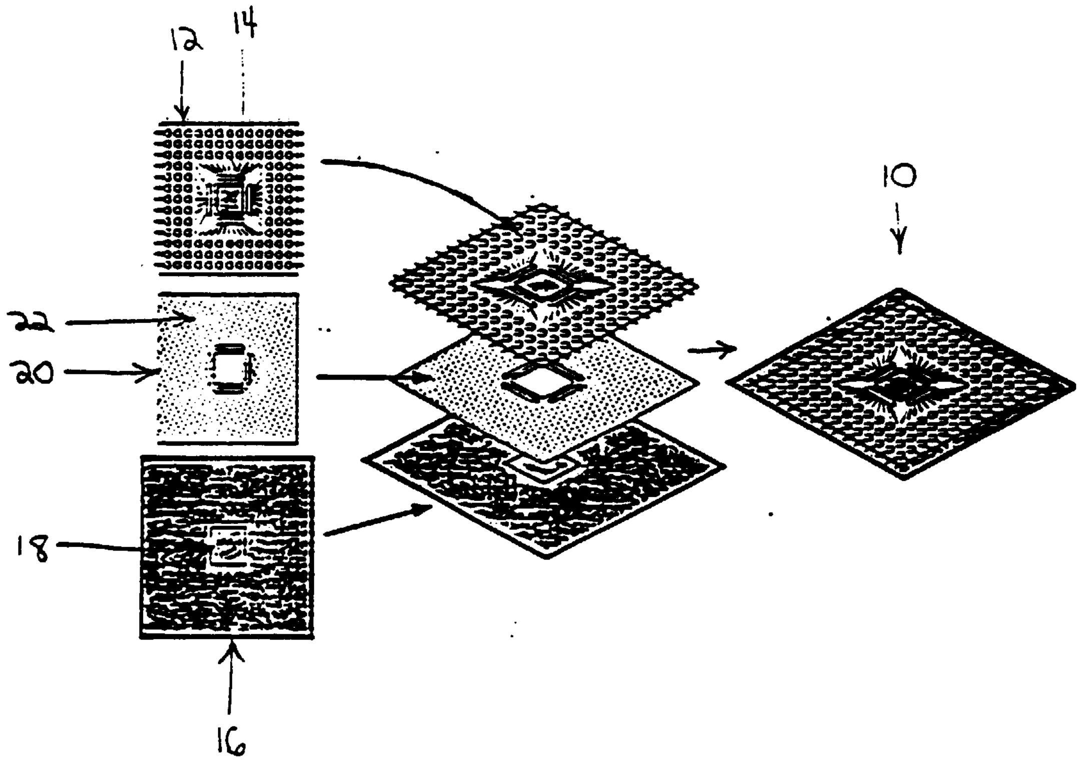


FIG. 1

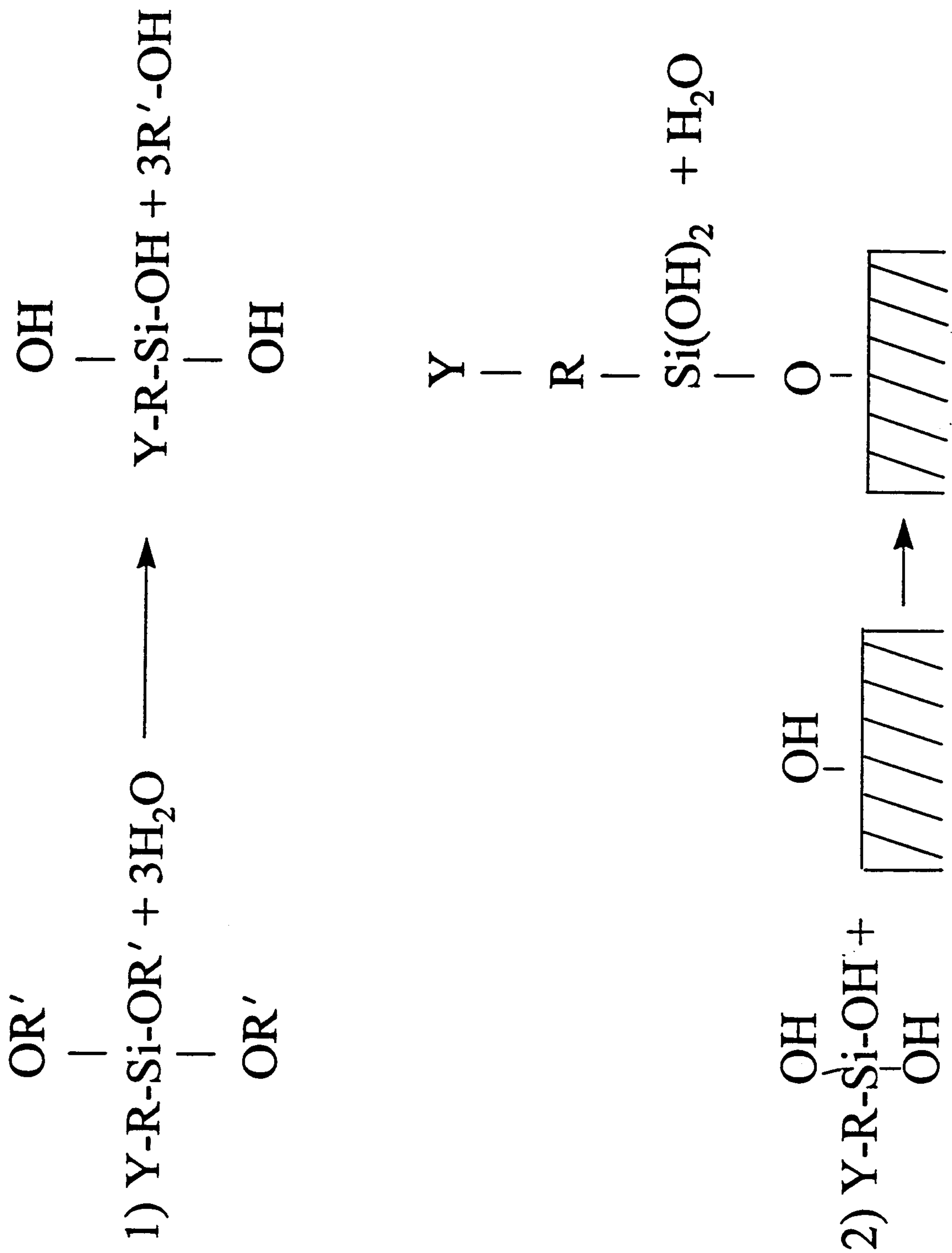

FIGURE 2

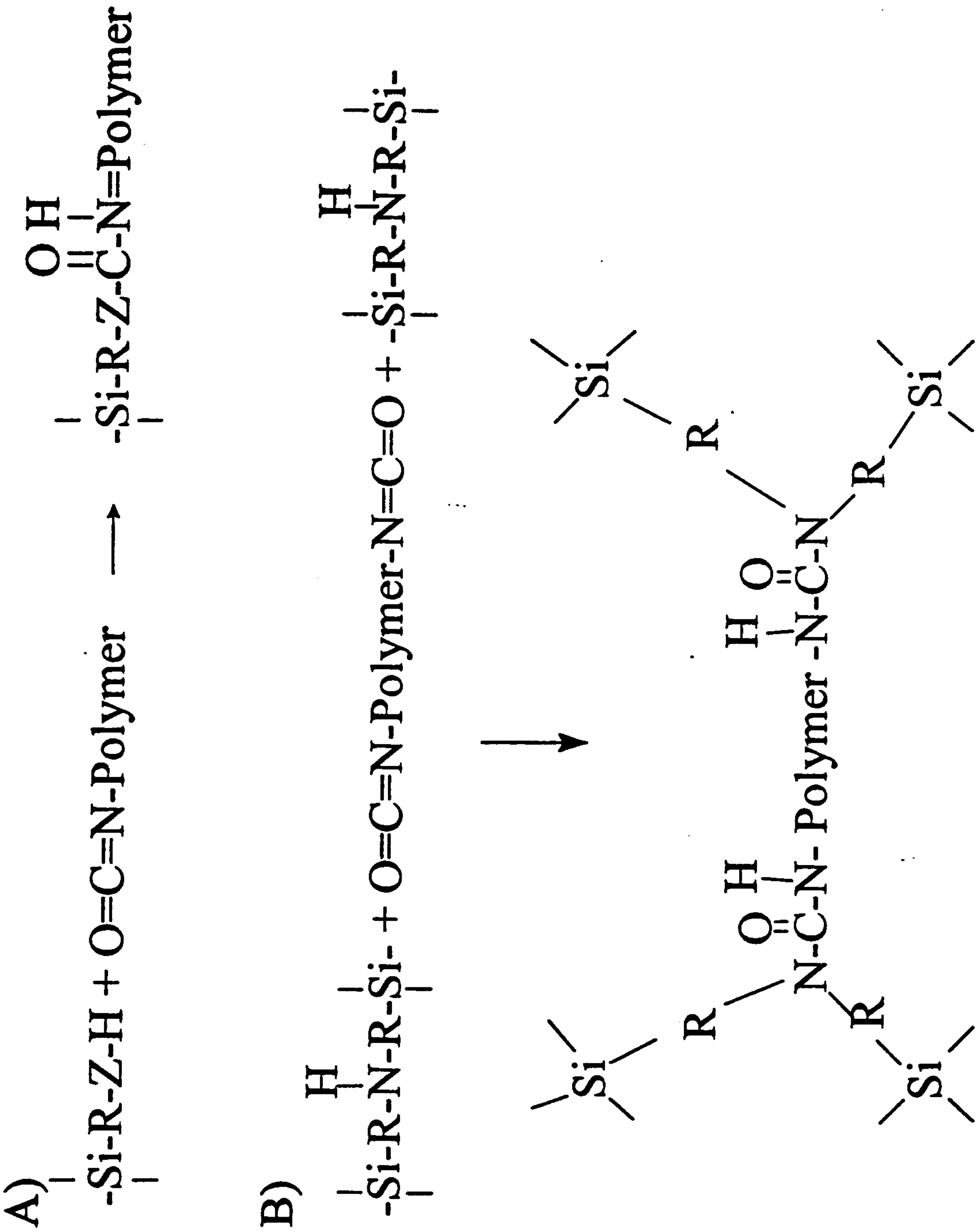

FIGURE 3

A)

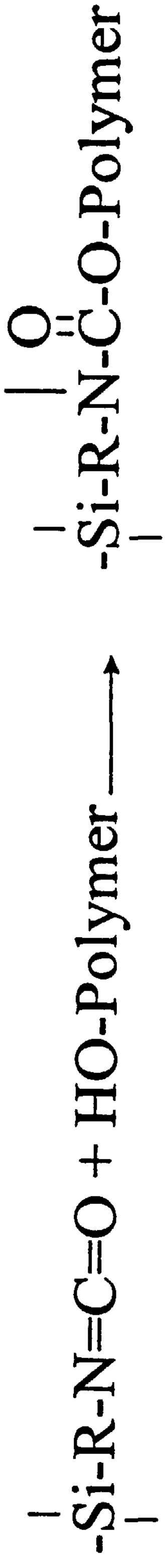

B)

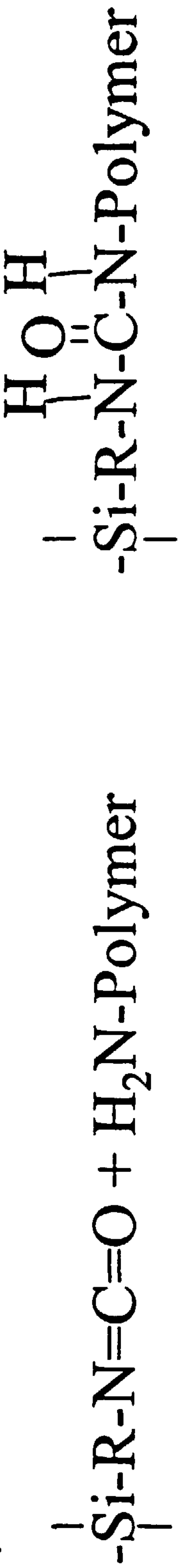

FIGURE 4

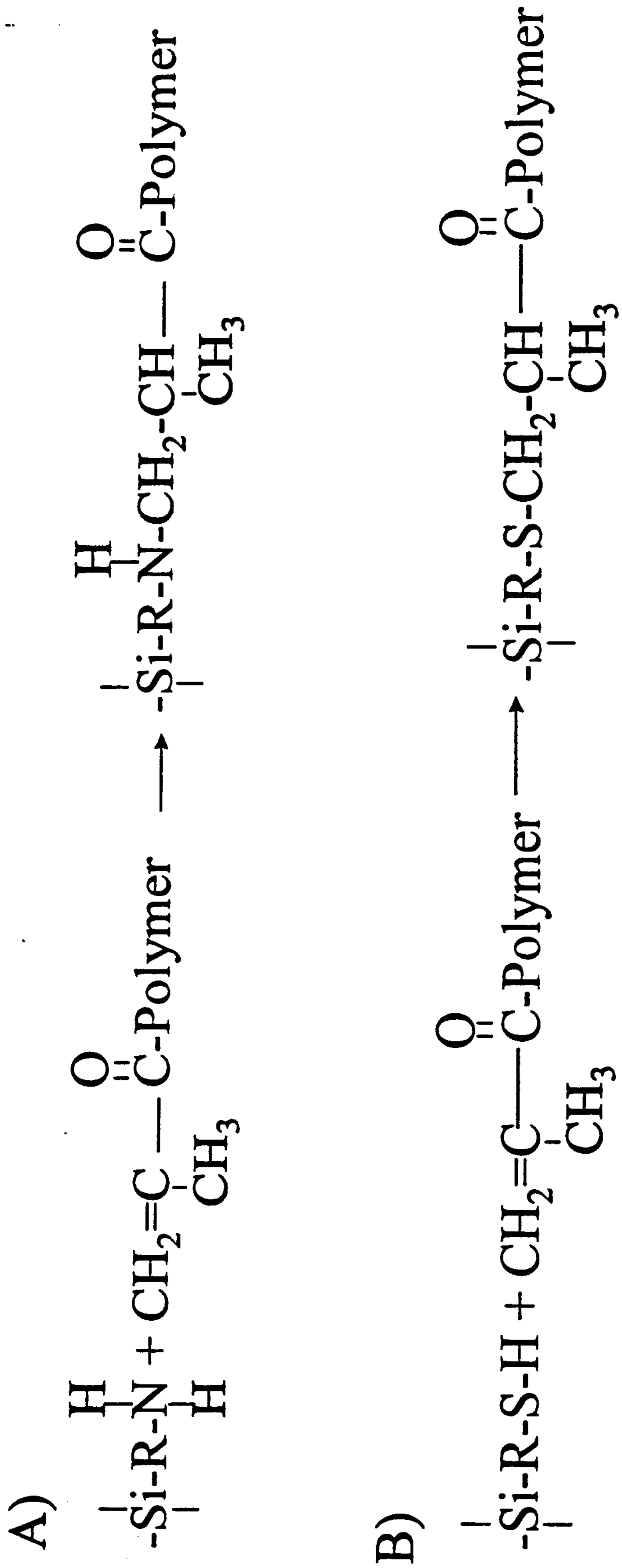

A)

B)

FIGURE 5

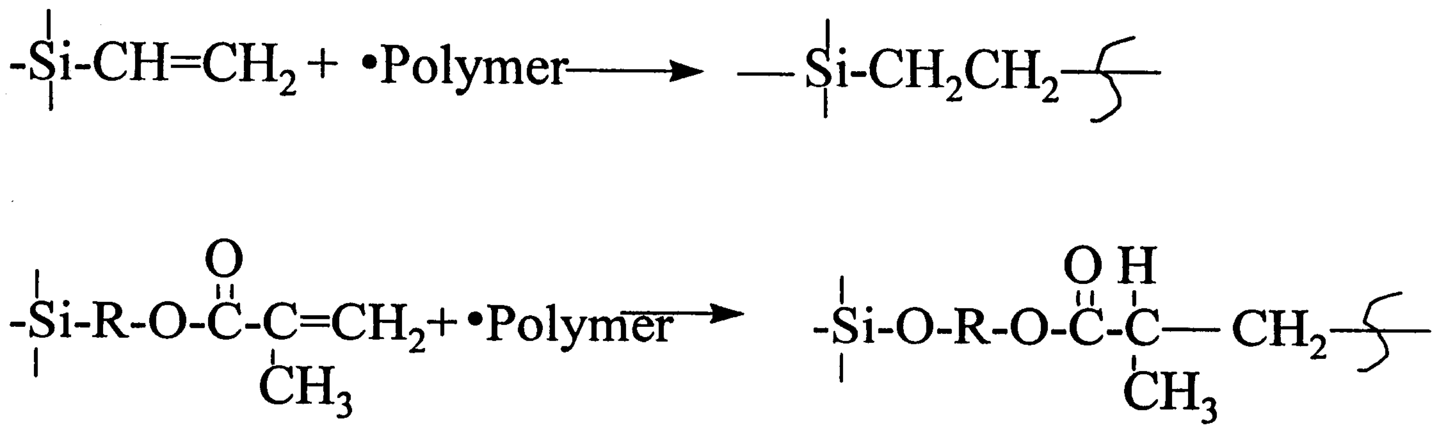

FIGURE 6

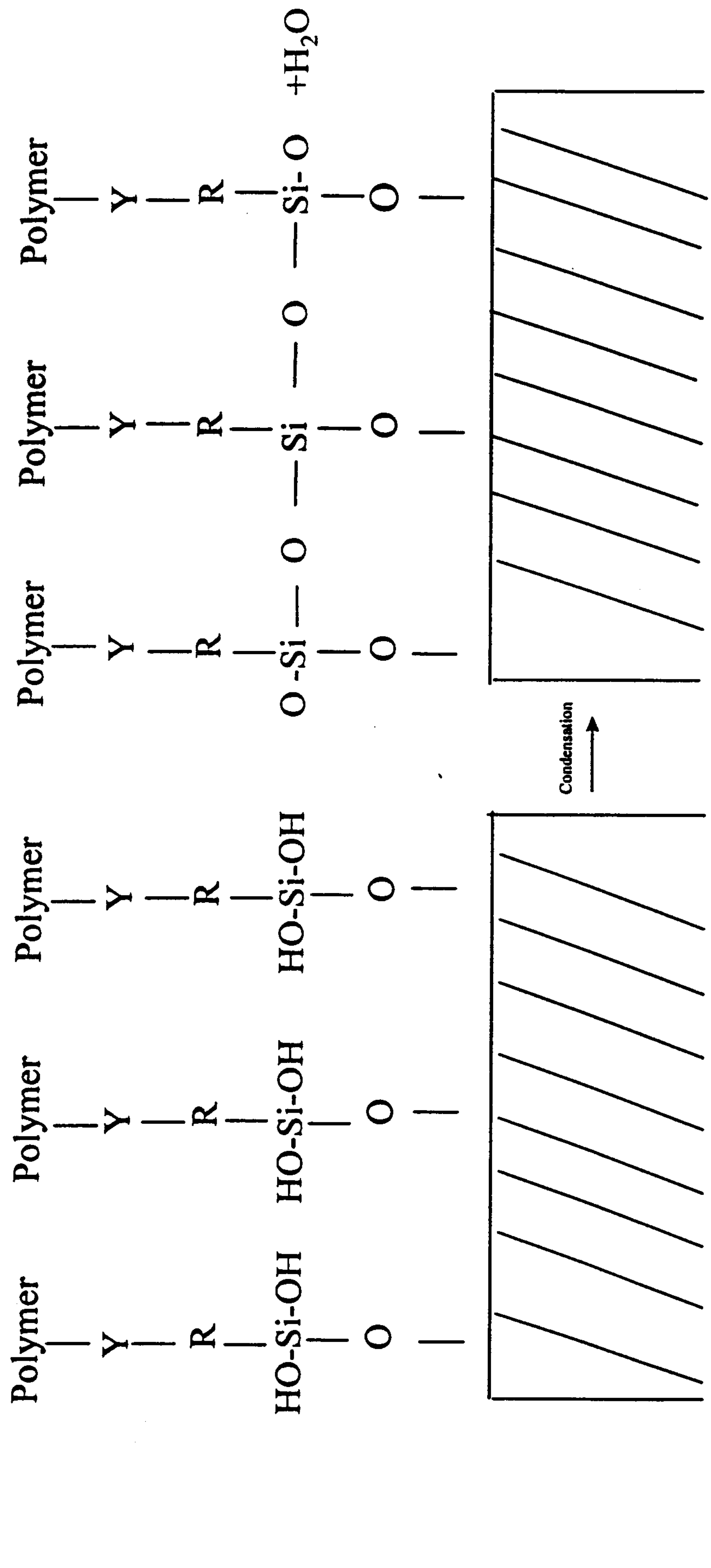


FIGURE 7

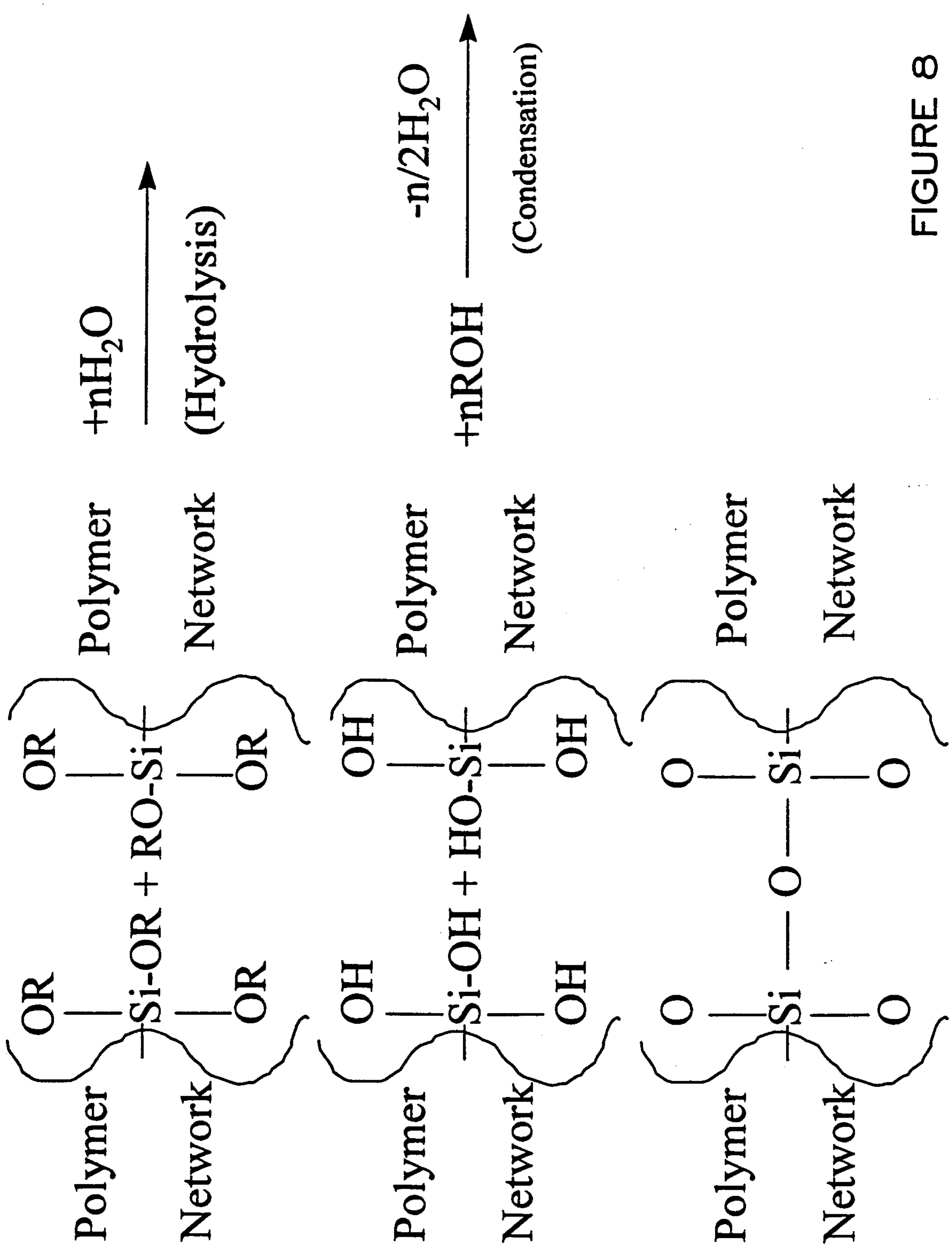


FIGURE 8